(19) Europäisches Patentamt
European Patent Office
Office européen des brevets

(11) **EP 3 143 415 B1**

(12) **EUROPÄISCHE PATENTSCHRIFT**

(45) Veröffentlichungstag und Bekanntmachung des Hinweises auf die Patenterteilung:
**08.11.2017 Patentblatt 2017/45**

(51) Int Cl.:
***G01R 31/08*** *(2006.01)*

(21) Anmeldenummer: **14771515.5**

(22) Anmeldetag: **19.09.2014**

(86) Internationale Anmeldenummer:
**PCT/EP2014/002549**

(87) Internationale Veröffentlichungsnummer:
**WO 2015/172798 (19.11.2015 Gazette 2015/46)**

(54) **VERFAHREN UND MESSGERÄT ZUR INTERMODULATIONSMESSUNG**

METHOD AND MEASURING DEVICE FOR INTERMODULATION MEASUREMENT

PROCÉDÉ ET APPAREIL DE MESURE D'INTERMODULATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.05.2014 DE 102014007151**

(43) Veröffentlichungstag der Anmeldung:
**22.03.2017 Patentblatt 2017/12**

(73) Patentinhaber: **Rosenberger Hochfrequenztechnik GmbH & Co. KG 83413 Fridolfing (DE)**

(72) Erfinder:
• **ENTSFELLNER, Christian**
  **83413 Fridolfing (DE)**
• **KAINDL, Benjamin**
  **83413 Fridolfing (DE)**
• **SCHWAB, Martin**
  **82538 Gelting (DE)**

(74) Vertreter: **Zeitler Volpert Kandlbinder Patent- und Rechtsanwälte Partnerschaft mbB Herrnstrasse 44 80539 München (DE)**

(56) Entgegenhaltungen:
**WO-A2-02/27983     US-A- 6 144 692**

• **SHANG WU ET AL: "Noncontact Probes for Wire FaultLocation With Reflectometry", IEEE SENSORS JOURNAL, IEEE SERVICE CENTER, NEW YORK, NY, US, Bd. 6, Nr. 6, 1. Dezember 2006 (2006-12-01), Seiten 1716-1721, XP011150512, ISSN: 1530-437X, DOI: 10.1109/JSEN.2006.884560**

## Beschreibung

Die vorliegende Erfindung betrifft ein Verfahren zum Orten von Stellen in einem Signalübertragungspfad (400) für ein Hochfrequenzsignal, die im Sinne von Hochfrequenzübertragungseigenschaften des Signalübertragungspfades fehlerhaft sind, wobei ein erstes HF-Signals $u_{Test}$ mit einer Trägerfrequenz $f_1$ erzeugt wird, gemäß dem Oberbegriff von Anspruch 1. Ferner betrifft die Erfindung ein Messgerät zur bandbreitenoptimierten Entfernungsmessung in PIM-Messgeräten.

Beschreibung von PIM

Die Qualität einer Verbindung zwischen einer fest installierten Sende- und Empfangseinrichtung (BTS, base transceiver station) und einem Endgerät (UE, user equipment) spielt in heutigen Mobilfunknetzen eine wesentliche Rolle. Durch die hohe erzeugte Sende-Leistung in der BTS einerseits und die notwendige Empfindlichkeit der Empfänger der BTS und UE andererseits können Störungen im Übertragungsweg die Empfindlichkeit der Empfänger und damit die Qualität der Verbindung wesentlich beeinflussen.

Ein maßgeblicher Effekt, welcher Störungen im Übertragungsweg hervorruft, ist die Intermodulation. Dabei erzeugen beispielsweise zwei Sendesignale mit zwei verschiedenen Trägerfrequenzen, welche mit hoher Leistung in einer BTS erzeugt werden, durch Intermodulation an Stellen mit nichtlinearem Übertragungsverhalten (oft einfach "Nichtlinearitäten" genannt) Störungen, deren Frequenzen Summen und Differenzen ganzzahliger Vielfacher der Frequenzen der Sendesignale sind. Ein Teil dieser Störungen kann in das Empfangsband der BTS fallen und damit die Qualität der Kommunikation beeinträchtigen. Werden diese Störungen an passiven Elementen erzeugt, spricht man von passiver Intermodulation (PIM).

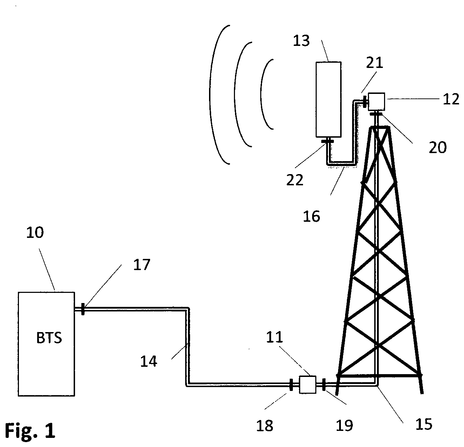

Fig. 1 ist eine schematische Darstellung, die einen Signalübertragungspfad von einer BTS bis zu einer Antenne zeigt. Die BTS 10 ist über ein erstes Filter 11 und ein zweites Filter 12 mit der Antenne 13 verbunden. Die BTS 10, die Filter 11 und 12 und die Antenne 13 sind über Hochfrequenzkabel 14, 15 und 16 miteinander verbunden, die über Hochfrequenzverbinder 17 bis 22 an die jeweiligen Elemente angeschlossen sind. In allen Komponenten 11 bis 22 des Übertragungsweges kann PIM auftreten. Beispielsweise können Korrosion in Steckverbindern, Oxydschichten an Kontakten und Metall-Metall-Übergängen, Verunreinigungen in Materialien und ungenügend befestigte Steckverbindungen PIM hervorrufen.

Zur Sicherstellung und Überprüfung der Qualität der Übertragungseinrichtung werden Messungen der PIM durchgeführt. Da PIM insbesondere bei hohen Leistungen auftritt, wird diese in der Regel bei Anwendung von hoher Sendeleistung, z.B. 2 * 20 W, gemessen. Von besonderer Bedeutung für die Messung an einer Übertragungseinrichtung gemäß Fig.1 ist es, eine mögliche Störung entlang des Übertragungsweges von BTS 10 bis zur Antenne 13 lokalisieren zu können um mangelhafte Komponenten im Übertragungsweg zu identifizieren und gezielt die Störung zu beseitigen. Eine hohe Auflösung bis beispielsweise in den 10cm-Bereich vereinfacht wesentlich die Fehlersuche.

Die Druckschrift DE 199 46 763 A1 beschreibt ein Verfahren zum Messen von Leitungseigenschaften einer Telekommunikationsleitung. Dabei wird ein von dem Leitungsende reflektiertes Echosignal ausgewertet. Zur Ortung von Stellen mit nichtlinearem Übertragungsverhalten ist dieses Verfahren nicht einsetzbar.

Stellen mit nichtlinearem Übertragungsverhalten können durch das in der Druckschrift DE 10 2012 023 448 A1 beschriebene Verfahren geortet werden. Dieses Verfahren ist allerdings mit einem erheblichen Messaufwand verbunden, da dafür mehrere HF-Signale und daraus ein Intermodulationsprodukt zu erzeugen sind, und eine Kreuzkorrelation zwischen Intermodulationsprodukt-Signalen durchzuführen ist. Aufgrund seiner Komplexität kann dieses Verfahren zu einer unzureichenden Ortsauflösung führen.

Aus der gattungsgemäßen Durchschrift WO 02/27983 A1 ist ein Verfahren zum Messen der Entfernung einer Fehlerstelle in einem Signalübertragungspfad bekannt. Hierbei wird ein von einer fehlerhaften Stelle rückreflektiertes Signal ("fault-induced reflected path signal"), das in einer Rückwärtsrichtung entlang des Signalübertragungspfads propagiert, mittels eines Kopplers aus dem Signalübertragungspfad ausgekoppelt und mit dem in einer Vorwärtsrichtung propagierenden Signal verglichen. Die Position der fehlerhaften Stelle kann so grob abgeschätzt werden.

Aufbau von PIM Messgeräten

Der Aufbau eines bekannten PIM Messgeräts ist in der Druckschrift DE 10 2010 015 102 A1 beschrieben. Ein solches Messgerät ist in Fig. 2 dargestellt und wird im Folgenden kurz erläutert.

PIM Entfernungsmessung

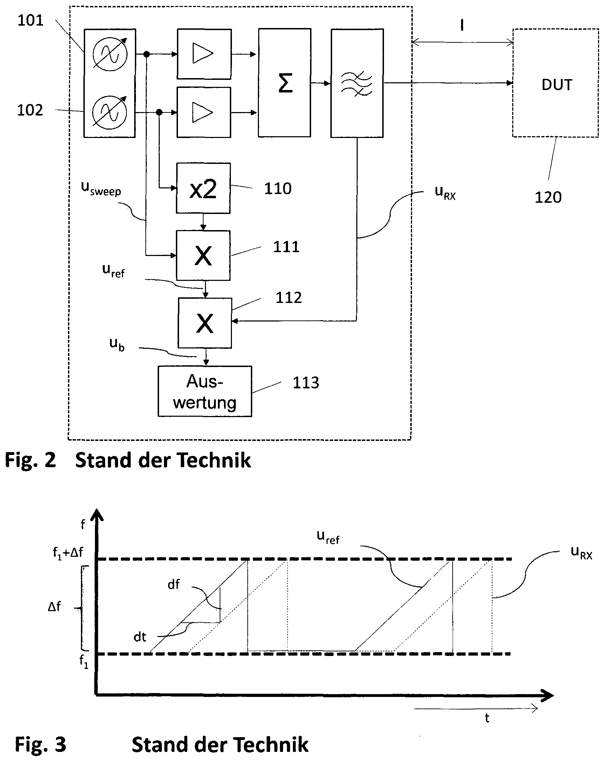

In zwei Signalquellen 101 und 102 werden Signale mit den Frequenzen $f_1$ und $f_2$ erzeugt, wobei das Signal $u_{sweep}$ der Signalquelle 101 über einen definierten Frequenzbereich $\Delta f$ startend mit der Frequenz $f_1$ periodisch gesweept wird. Die Frequenz des Signals $u_{sweep}$ ist beispielhaft in Fig. 3 dargestellt. Das Signal $u_{sweep}$ wird durch Multiplikation im Mischer 111 mit dem im Frequenzverdoppler verdoppelten Signals der Signalquelle 102 derart modifiziert, dass das resultierende Signal $u_{ref}$ dem im Signalübertragungspfad bzw. im DUT 120 erzeugten PIM-Signal in Bezug auf Frequenz und Signalform gleicht. Durch die Laufzeit der PIM im Signalübertragungspfad über die Wegstrecke I wird $u_{rx}$ im Vergleich zu $u_{ref}$ um dt verzögert empfangen, wobei gilt:

$$dt = \frac{2l\varepsilon_{reff}}{c_0} \qquad (1)$$

$c_0$ gibt dabei die Lichtgeschwindigkeit, $\varepsilon_{reff}$ die effektive Dielektrizitätskonstante des Kabels mit der Wegstrecke l an. In Fig. 3 wird verdeutlicht, dass die zeitliche Verzögerung dt im Vergleich zum Signal $u_{ref}$ einen Frequenzunterschied df zwischen $u_{ref}$ und $u_{rx}$ hervorruft. Durch Multiplikation der Signale $u_{ref}$ und $u_{rx}$ im Mischer 112 wird das Signal $u_b$ erzeugt. Die Frequenz von $u_b$ ist ein Maß für die Entfernung I der Störung zum Messgerät. Die Berechnung der Entfernung I aus $u_b$ erfolgt in der Auswertungs-Einheit 113.

Welches Problem wird gelöst

Die Übertragungseinrichtungen gemäß Fig. 1 sind bandbreitenbegrenzte Systeme. Die Filter 11 und 12, sowie Filter innerhalb der BTS begrenzen üblicherweise die Bandbreite auf das für die Übertragungseinrichtung relevante Sende- und Empfangsband. Durch die eingeschränkte Bandbreite einerseits und das wenig bandbreiten-effiziente Frequenzmodulationsverfahren andererseits existieren Grenzen der örtlichen Auflösung von Störungen, welche die Genauigkeit des Messverfahrens gemäß DE 10 2010 015 102 A1 einschränken.

In Anbetracht der beschriebenen Probleme liegt der Erfindung die Aufgabe zugrunde, ein Verfahren der o.g. Art derart auszugestalten, dass aus HFtechnischer Sicht fehlerhafte Stellen in einem Signalübertragungspfad örtlich möglichst genau lokalisiert werden können, so dass die Fehlersuche vereinfacht wird, wobei das Verfahren einfach und ohne größeren Messaufwand durchführbar sein soll.

Diese Aufgabe wird erfindungsgemäß durch ein Verfahren der o.g. Art mit den in Anspruch 1 angegebenen Verfahrensschritten gelöst. Vorteilhafte Ausgestaltungen der Erfindung sind in den weiteren Ansprüchen beschrieben.

Bei einem Verfahren der o.g. Art sind erfindungsgemäß folgende Verfahrensschritte vorgesehen:

(a) Aufmodulieren eines digitalen Signals $u_{Code}$ auf das erste HF-Signal $u_{Test}$;;
(b) Erzeugen eines zweiten HF-Signals $u_2$ mit einer Frequenz $f_2$;
(c) Einleiten des ersten HF-Signals $u_{Test}$ und des zweiten HF-Signals $u_2$ in den Signalübertragungspfad an einem vorbestimmten Einleitungspunkt;
(d) Empfangen eines in dem Signalübertragungspfad aus dem ersten HF-Signal und dem zweiten HF-Signal an zumindest einer fehlerhaften Stelle erzeugten Intermodulationsprodukts in Form eines Intermodulationsprodukt-Signals $u_{RX}$;
(e) Rückgewinnung eines digitalen Signals $u_{demod}$ aus dem Intermodulationsprodukt-Signal; und
(f) Bestimmen einer Zeitverschiebung $t_x$ zwischen

dem digitalen Signal $u_{Code}$ und dem rückgewonnenen digitalen Signal $u_{demod}$
(g) Berechnen einer Länge L zwischen dem Einleitungspunkt und derjenigen Stelle in dem Signalübertragungspfad, an der das in Schritt (d) empfangene Signal erzeugt wurde, aus der in Schritt (f) bestimmten Zeitverschiebung $t_x$.

Bei dem in Schritt (d) empfangenen Intermodulationsprodukt kann es sich um ein von einer Stelle mit nichtlinearer Übertragungsfunktion zum Einleitungspunkt zurückreflektiertes Intermodulationsprodukt handeln.

Die Rückgewinnung des digitalen Signals aus dem Intermodulationsprodukt-Signal in Schritt (e) kann insbesondere eine Demodulation und/oder eine Analog-Digital-Konvertierung umfassen.

Digitale Signale umfassen auch digitalisierte Signale.

Das erfindungsgemäße Verfahren hat den Vorteil, dass Stellen mit nichtlinearer Übertragungsfunktion im Signalübertragungspfad örtlich sehr genau lokalisiert werden können, ohne hierzu den Signalübertragungspfad mechanisch bearbeiten zu müssen. Dadurch wird die Fehlersuche erheblich vereinfacht und verkürzt, da binnen kurzer Zeit festgestellt werden kann, welches Bauteil des Signalübertragungspfades einen Fehler aufweist und wo in diesem Bauteil der Fehler örtlich vorhanden ist. Hierbei erfolgt die Bestimmung des Ortes der fehlerhaften Stelle auf einfache Weise mit geringem apparativem Aufwand und ohne aufwändige Rechenoperationen.

Das erfindungsgemäße Verfahren hat gegenüber dem in der Druckschrift DE 10 2012 023 448 A1 beschriebenen Verfahren den Vorteil, dass aus dem ersten HF-Signal und aus dem zweiten HF-Signal kein Intermodulationsprodukt künstlich erzeugt werden muss, um dieses erzeugte Intermodulationsprodukt mit dem von der fehlerhaften Stelle rückreflektierten Intermodulationsprodukt zu korrelieren. Dadurch werden die Messanordnung und die Messdurchführung stark vereinfacht.

Die Erfindung geht auf die Erkenntnis zurück, dass ein digitales Signal auch bei einer nichtlinearen Umwandlung eines HF-Signals, das das digitale Signal in aufmodulierter Form enthält, insbesondere auch nach der Erzeugung eines Intermodulationsproduktes aus dem HF-Signal, in dem Intermodulationsprodukt noch immer als solches enthalten ist und daraus insbes. durch Demodulation extrahiert werden kann. Auch wenn durch den nichtlinearen Prozess ein zusätzliches Signal mit einer geänderten Grundfrequenz entsteht, kann das ursprüngliche digitale Signal hiervon entkoppelt und in seiner ursprünglichen Form wiedergewonnen werden. Mit anderen Worten wird erfindungsgemäß die neue Grundfrequenz des aus den beiden HF-Signalen generierten Mischprodukts zum Filtern des Intermodulationsprodukts aus dem rückreflektierten Signal verwendet, während die Zeitverschiebung zur Berechnung der Lage der Fehlstelle zwischen dem ursprünglichen digitalen Signal und dem aus dem Intermodulationsprodukt rückgewinnbaren digitalen Signal bestimmt wird.

Ferner kann eine Zeitverschiebung zwischen zwei digitalen Signalen weitaus präziser und einfacher bestimmt werden als zwischen zwei analogen Signalen wie etwa gemäß der Druckschrift DE 10 2010 015 102 A1.

Eine mathematisch besonders einfache Bestimmung der Länge I zwischen der fehlerhaften Stelle und dem Einleitungspunkt oder einer Referenzebene des Signalübertragungspfads erzielt man dadurch, dass die Länge I gemäß der Formel $l = \frac{1}{2} \cdot t_x \cdot c$ berechnet wird, wobei c eine Ausbreitungsgeschwindigkeit von HF-Signalen in dem Signalübertragungspfad ist, mit c= $c_0$ / $\varepsilon_{reff}$. Die Länge I wird dabei von dem Signal zweimal (Hin- und Rückweg) durchlaufen. Ggf. kann noch eine Korrektur um voneinander abweichende Laufzeiten innerhalb des Messgeräts erforderlich sein.

Ein besonders einfaches, schnelles und funktionssicheres Verfahren erzielt man dadurch, dass in Schritt (f) das digitale Signal $u_{Code}$ und das rückgewonnene digitale Signal $u_{demod}$ in ihrer Phasenlage relativ zueinander solange gegeneinander verschoben werden, bis die digitalen Signale deckungsgleich sind, wobei aus der Phasenverschiebung für die Deckungsgleichheit die Zeitdifferenz $t_x$ bestimmt wird.

In einer besonders bevorzugten Ausführungsform der Erfindung wird die Zeitverschiebung in Schritt (f) mittels einer Kreuzkorrelation und/oder einer Faltung zwischen den beiden digitalen Signalen $u_{demod}$ und $u_{Code}$ bestimmt.

Unter einem digitalen Signal wird erfindungsgemäß jedes Signal verstanden, welches einen abgegrenzten und gestuften Wertevorrat hat, bspw. ein binäres Signal ebenso wie ein digitalisiertes Signal. Das aufmodulierte Signal kann auch ein digitales Rauschsignal, insbesondere ein Quasirauschen oder Pseudo Noise sein. Dies ist besonders vorteilhaft, da eine Kreuzrelation zwischen zwei übereinstimmenden Rauschsignalen einen besonders scharfen Peak bei zeitlicher Überlappung der Signale aufweist, so dass die fehlerhafte Stelle leicht zu orten ist.

In Schritt (e) kann das digitale Signal aus dem Intermodulationsprodukt-Signal mittels einer Analog/Digital-Konvertierung und/oder einer Demodulation gewonnen werden.

Das Verfahren ist apparativ besonders einfach und funktionssicher dadurch auszuführen, dass die Modulationsart eine Amplitudenmodulation (AM), eine Frequenzmodulation (FM), eine Phasenmodulation (PM), eine Quadraturamplitudenmodulation (QAM) oder eine andere I/Q-Modulation ist.

Eine besonders genaue Ortsbestimmung bei einfachem technischem Aufbau erzielt man dadurch, dass in Schritt (d) ein Intermodulationsprodukt dritter Ordnung IM3, insbesondere das Intermodulationsprodukt IM3 mit der Trägerfrequenz $2xf_1$-$f_2$ oder $2xf_2$-$f_1$ empfangen wird. Intermodulationsprodukte dritter Ordnung werden an einer fehlerhaften Stelle regelmäßig in stärkerem Maß erzeugt als Intermodulationsprodukte höherer Ordnung, wobei gleichzeitig ihre Trägerfrequenz in einem Empfangsband RX des Signalübertragungspfads liegen kann, während $f_1$ und/oder $f_2$ in einem Sende-Frequenzbereich des Signalübertragungspfads liegen können (vorzugsweise gilt dabei $f_1$ ungleich $f_2$). Dadurch wird die Detektion vereinfacht und es werden Frequenzbereiche vermessen, die für die spätere Verwendung des Signalübertragungspfads relevant sind. Alternativ können auch Intermodulationsprodukte anderer Ordnung wie etwa zweiter, fünfter, siebter Ordnung o.dgl. empfangen werden.

Eine Stelle, welche im Sinne von Hochfrequenzübertragungseigenschaften des Signalübertragungspfades fehlerhaft ist, kann wenigstens eine Stelle umfassen, an der eine Änderung, insbesondere ein Sprung, des HF-Wellenwiderstandes vorliegt, an der eine elektrische Kontaktierung fehlerhaft ist, insbesondere ein Kontaktwiderstand vorliegt, welcher größer als ein vorbestimmter Wert ist, und/oder an der eine nichtlineare Übertragungsfunktion für ein HF-Signal vorliegt. Das zweite HF-Signal kann ein reines Sinussignal der (Träger-)Frequenz $f_2$ ohne ein aufmoduliertes Signal sein.

Im Folgenden soll das auf die Trägerfrequenz $f_1$ gemäß einer besonders bevorzugten Ausführungsform der Erfindung aufzumodulierende digitale Signal näher erläutert werden.

Es hat sich als besonders zweckmäßig erwiesen, ein Binärsignal auf die Trägerfrequenz $f_1$ aufzumodulieren. Das Binärsignal kann bspw. den Wertebereich 0 und 1 oder alternativ den Wertebereich -1 und +1 haben. Ein Binärsignal ist mit vergleichsweise einfachen Mitteln erzeugbar und verarbeitbar.

Insbesondere weist das Digitalsignal ein vorzugsweise periodisches Frame-Taktsignal $u_{frame}$ mit einer vorgegebenen Taktdauer $t_f$ auf. Die Periodendauer 2 * $t_f$ des Taktsignals kann an eine Bandbreite des Signalübertragungspfads angepasst sein.

Zum Verbessern des Signal-Rauschverhältnisses bei der Ortung von Fehlstellen kann zur Erzeugung des digitalen Signals ein digitales Basissignal, insbesondere das periodische Frame-Taktsignal, mit einem Spreizcode multipliziert werden. Der Spreizcode besteht vorzugsweise aus einer Folge von bevorzugt binären Chips wie etwa {-1, +1} oder {0, 1}. Die Anzahl der Chips des Spreizcodes ist $I_C$ und die Dauer eines Chips beträgt $t_c$. Die Folge der Chips wird zweckmäßigerweise derart gewählt, dass die Autokorrelation der Chipfolge für Verschiebungen ungleich 0 minimal ist, während die Autokorrelation ein Maximum bei Verschiebungen gleich 0 haben sollte.

Gemäß einer besonders bevorzugten Ausführungsform wird zur Erzeugung des digitalen Signals $u_{Code}$ ein periodisches Frame-Taktsignal $u_{frame}$ mit einem solchen Spreizcode $u_{code}$ multipliziert. Auf diese Weise entsteht in einer Spreizungseinheit eine sich wiederholende Folge von digitalen Impulsen durch zyklische Multiplikation von $u_{Frame}$ mit dem Spreizcode. Die Chipdauer $t_C$ ist dabei gegeben durch $t_C = t_f / I_C$. Hierdurch kann ein digitales Basissignal künstlich aufgeweitet werden, wodurch zum einen das Signal-Rauschverhältnis im Detektor verbessert werden kann und zum anderen eine spektrale Anpassung an die Bandbreite des Sendebands TX und/oder des Empfangsbands RX möglich ist.

Durch entsprechende Einstellung der Parameter $t_f$ des Frame-Taktsignals, $t_c$ der Chips, der Chipfolge und/oder der Anzahl der Chips des Spreizcodes $I_C$ kann das digitale Signal $u_{Code}$ im Hinblick auf die Länge des Signalübertragungspfads, das gewünschte Signal-Rauschverhältnis, eine zu erzielende Ortsauflösung, eine zu verwendende Sendebandbreite und/oder eine zu verwendende Empfangsbandbreite eingestellt werden. Eine Veränderung der genannten Parameter wirkt sich auch auf die Bandbreite des ersten HF-Signals $u_{Test}$ und des daraus zu erzeugenden und zu empfangenden Intermodulationsproduktsignals $u_{RX}$ aus.

Vorzugsweise wird das digitale Signal $u_{Code}$ mit einem bandbreiteneffizienten Modulationsverfahren auf einen Hochfrequenzträger mit der Trägerfrequenz $f_1$ aufmoduliert. Vorzugsweise wird ein Modulationsverfahren verwendet, bei dem die Zeiger der Symbole im Konstellationsdiagramm dieselbe Länge haben. Wenn nämlich die Zeiger dieselbe Länge haben, können kostengünstigere Verstärker zur Anwendung kommen im Vergleich zu Verfahren mit variabler Länge des Signal-Zeigers. Als besonders zweckmäßig haben sich digitale Modulationsverfahren wie frequency shift keying, phase shift keying, continuous-phase frequency shift keying o.dgl. erwiesen. Vorteilhaft sind Modulationsverfahren mit einer benötigten Bandbreite B, innerhalb welcher 99% der Signalenergie liegen, von weniger als $1,5 / t_c$, insbesondere weniger als $1,2 / t_c$, wobei $1/t_c$ die Chipfrequenz ist. Optimal im Hinblick auf die benötigte Bandbreite B ist Minimum Shift Keying MSK als Modulationsverfahren.

Bei einem HF-Signal mit der Trägerfrequenz $f_1$ und einem zweiten HF-Signal mit der Frequenz $f_2$ ergibt sich eine Trägerfrequenz des Intermodulationsprodukt-Signals $u_{RX}$ von $f_{PIM} = nf_1 + mf_2$ mit $o=|n|+|m|$, vorzugsweise $o=3$. In diesem Fall weist das Signal $u_{RX}$ im Falle von MSK als Modulationsverfahren die Bandbreite $B_{RX} = 1,18 \cdot o / t_c$ auf.

Gemäß einem wichtigen Aspekt beruht die vorliegende Erfindung auf der Grundidee, eine exakte Entfernungsmessung einer Störstelle bei einem PIM-Messgerät durch ein bandbreiteneffizientes Modulationsverfahren in Kombination mit einem Code-Spreizverfahren zu erreichen. Dabei kann mit mindestens drei Empfängern zeitlich versetzt die Leistung des Intermodulationsprodukt-Signals (auch genannt "PIM Signal") gemessen werden. Ferner kann mit einem mathematischen Verfahren aus den gemessenen drei Leistungen die Lage der Störung mit großer Genauigkeit berechnet werden.

Durch Demodulation und ggf. Digitalisierung kann ein digitales Signal $u_{demod}$ aus dem Intermodulationsprodukt-Signal $u_{RX}$ zurückgewonnen werden. Das in Schritt (a) aufmodulierte digitale Signal $u_{Code}$, insbesondere das mit einem Spreizcode $u_{Code}$, multiplizierte digitale Basissignal $u_{frame}$, ist in dem rückgewonnenen digitalen Signal $u_{demod}$ enthalten.

Im Hinblick auf eine einfache, aber dennoch zuverlässige und exakte Bestimmung der Zeitverschiebung in Schritt (f) hat es sich als vorteilhaft erwiesen, das rückgewonnene digitale Signal $u_{demod}$ (oder alternativ das Signal $u_{Code}$) mit unterschiedlichen vorgegebenen Verzögerungen, bspw. in einem Abstand von jeweils einem vorgegebenen Bruchteil einer Chipdauer $t_C$, insbesondere etwa einer halben Chipdauer, an drei oder mehr Empfänger zu leiten und darin jeweils mit dem digitalen Signal $u_{Code}$ (oder alternativ dem Signal $u_{demod}$) zu vergleichen, insbesondere durch Multiplikation von $u_{demod}$ mit $u_{Code}$. Zu diesem Zweck kann das digitale Signal $u_{demod}$ (oder alternativ das Signal $u_{Code}$) über drei oder mehr Verzögerungsglieder geleitet und jeweils einem Detektor zugeführt werden. Dies führt zu einem klar definierten und gut sichtbarem Maximum des Produkts zwischen $u_{Code}$ und $u_{demod}$ in den Detektoren bei einer vorgegebenen Verzögerungszeit zwischen $u_{Code}$ und $u_{demod}$.

Das Produkt zwischen dem digitalen Signal $u_{Code}$ und dem rückgewonnenen digitalen Signal $u_{demod}$ in Abhängigkeit von der Zeitverschiebung zwischen diesen Signalen kann im Bereich eines Maximums durch eine Polynomfunktion, insbesondere durch eine Parabel angenähert werden. Die Koeffizienten der Polynomfunktion können aus den von den drei oder mehr Detektoren, die jeweils um eine vorgegebene Zeitverzögerung versetzt messen, zum selben Zeitpunkt erfassten Produktwerten, die vorzugsweise um das Maximum herum verteilt liegen, zumindest näherungsweise bestimmt werden. Aus den Koeffizienten der Polynomfunktion kann dann die exakte Lage des Maximums des Polynoms berechnet werden, aus dem der Laufzeitunterschied zwischen den Signalen $u_{Code}$ und $u_{demod}$ bestimmbar ist.

Der wesentliche Vorteil dieses Verfahrens ist die hohe Genauigkeit und Ortsauflösung, die erreicht werden kann.

Alternativ oder zusätzlich ist eine Kreuzkorrelation und/oder Faltung zwischen $u_{Code}$ und $u_{demod}$ zur Bestimmung der Zeitverschiebung möglich.

Bei dem erfindungsgemäßen Verfahren können insbesondere die folgenden Schritte vorgesehen sein:

a) Berechnung aus dem TX- und RX-Band eines ein "Device under Test" (DUT) aufweisenden Signalübertragungspfads einer ersten Trägerfrequenz $f_1$, einer zweiten Frequenz $f_2$, der Frequenz eines Intermodulationsprodukt-Signals $f_{PIM}$ bzw. der Ordnung der Störung o;

b) Berechnung einer Frame-Takt-Länge und einer Spreizcode-Länge derart, dass die zusammen mit dem Modulationsverfahren resultierende Bandbreite die Bandbreite des Signalübertragungspfads nicht überschreitet;

c) Erzeugen eines Frame-Taktes;

d) Erzeugung eines Spreizcodes mit der in Schritt b) berechneten Länge;

e) Erzeugung einer Chip-Sequenz durch Multiplikation des Frame-Taktes mit dem Code;

f) Modulation eines Trägers mit der Chipsequenz; Wahl des Modulationsverfahrens derart, dass nach Spreizung des Signals an der fehlerhaften Stelle das zu empfangende Signal die gewünschte Form hat;

g) Übertragung des Signals im Signalübertragungspfad, vorzugsweise aufweisend einen Verstärker, eine zweite, vorzugsweise sinusförmige Signalquelle, einen Combiner, einen Filter und/oder eine DUT;

h) Demodulation des Signals aus dem Signalübertragungspfad;

i) Empfang des Signals mit mehreren, vorzugsweise jedoch mindestens 3 Empfängern welche zeitlich versetzt, z.B. um ½ Chip, empfangen, wobei der Empfangszeitpunkt eines der Empfänger so gewählt ist, dass sich maximale empfangene Leistung ergibt;

j) Messung der empfangenen Leistung der mindestens 3 Empfänger;

k) Ermittlung der Koeffizienten einer Approximation an den zeitlich verschobenen Verlauf der Empfangsleistung;

l) Berechnung des genauen Zeitpunkts des Maximums der Empfangsleistung aus den in k) ermittelten Koeffizienten.

m) Ermittlung des Ortes der fehlerhaften Stelle aus dem berechneten Zeitpunkt.

Mithilfe des erfindungsgemäßen Verfahrens können auch mehr als eine Fehlstelle mit nichtlinearer Übertragungsfunktion geortet werden sowie die Leistung der an diesen Fehlstellen einzeln bzw. insgesamt erzeugten Intermodulationsprodukte abgeschätzt werden.

Gemäß einer vorteilhaften Ausführungsform der Erfindung weist das in Schritt (d) empfangene Signal $u_{RX}$ an mehreren fehlerhaften Stellen des Signalübertragungspfads erzeugte Intermodulationssignalanteile auf, wobei mindestens eine Größe eines der Intermodulationssignalanteile wie etwa eine Zeitverschiebung bzgl. eines weiteren Intermodulationssignalanteils oder bzgl. des digitalen Signals $u_{Code}$, ein Verlauf, eine Amplitude, eine Leistung o.dgl. bestimmt werden. Mit anderen Worten werden die gegenseitigen Abstände von mehreren Fehlstellen, die Abstände der einzelnen Fehlstellen zu einem Einleitungspunkt oder einer Referenzebene des Signalübertragungspfads und/oder die erzeugte Intermodulationsproduktleistung erfasst. Dies gelingt insbesondere durch Wahl eines Spreizcodes und/oder eines Frametakts, die an die zu scannenden Abschnitte des Signalübertragungspfads angepasst sind.

Regelmäßig erzeugen auch Teile des Messgeräts selbst wie etwa Filter, Combiner o.dgl. in einem Eingangsabschnitt des Signalübertragungspfads Intermodulationsprodukte, wobei diese Eigen-Intermodulationsprodukte im Hinblick auf die Vermessung eines Messabschnitts des Signalübertragungspfads nicht von Interesse sind. Solche Intermodulationsprodukte werden mit residual PIM (rPIM) bezeichnet. Gemäß einer weiteren Ausführungsform der Erfindung können die generierten Intermodulationsprodukte ihrem Entstehungsort innerhalb des Signalübertragungspfads zugeordnet werden. Hierdurch ist es möglich, die in einem Eingangsabschnitt des Signalübertragungspfads erzeugte residual PIM bei einer Ortung von Fehlstellen und/oder bei einer Leistungsmessung der im Messabschnitt erzeugten PIM nicht zu berücksichtigen.

Insbesondere ist es durch das erfindungsgemäße Verfahren möglich, die Leistung der im Signalübertragungspfad erzeugten Intermodulation in Abhängigkeit von der Verzögerungszeit T zu messen, indem in dem Detektor die Verzögerungszeit zwischen $u_{Code}$ und $u_{demod}$ in vorgegebenen Verzögerungsschritten von T=0 bis $T=t_f$ erhöht wird, so dass der gesamte Signalübertragungspfad im Hinblick auf Fehlstellen gescannt wird. Die Schrittweite beträgt vorzugsweise einen Bruchteil der Chipdauer $t_c$ wie etwa die halbe Chipdauer.

Ferner ist es mittels des erfindungsgemäßen Verfahrens möglich, mindestens eine Gesamtgröße wie etwa die Gesamtleistung, die Signalstärke o.dgl. der in einem vorgegebenen Teilabschnitt wie etwa einem Eingangsabschnitt oder einem Messabschnitt des Signalübertragungspfads erzeugten Intermodulationsanteile zu bestimmen.

In Messgeräten nach dem Stand der Technik wird die Eigenstörung rPIM nicht gesondert erfasst. Die Auflösung herkömmlicher Messgeräte wird demnach durch die Eigenstörung rPIM begrenzt. Gemäß der vorliegenden Erfindung kann dagegen die Leistung der erzeugten Intermodulationsprodukte in Abhängigkeit von der Verzögerungszeit angezeigt werden, wobei bspw. nur Intermodulationsprodukte anzeigbar sind, die außerhalb des Messgeräts im Signalübertragungspfad erzeugt wurden. Alternativ oder zusätzlich werden die addierten PIM-Leistungen in einem vorgegebenen Abschnitt des Signalübertragungspfads bestimmt, addiert und/oder angezeigt.

Mit anderen Worten wird ein Maß für die Leistung von Intermodulationssignalanteilen in Abhängigkeit von ihrer Zeitverschiebung $t_x$ und/oder ein Maß für die addierte Leistung von Intermodulationssignalanteilen mit einer Verzögerungszeit $t_x > x$ bestimmt, wobei x eine vorgegebene Schwellenverzögerung $t_{min}$ ist.

Gemäß einem weiteren Gesichtspunkt betrifft die Erfindung ein Messgerät zum Durchführen des erfindungsgemäßen Verfahrens. Ein solches Messgerät weist auf: einen ersten Signalgenerator mit einem Modulator zum Erzeugen des ersten HF-Signals $u_{Test}$ mit einer Trägerfrequenz und einem aufmodulierten digitalen Signal, einen zweiten Signalgenerator zum Erzeugen des zweiten HF-Signals, einen Combiner zum Einleiten der beiden HF-Signale in den Signalübertragungspfad, einen Filter zum Empfangen eines in dem Signalübertragungspfad erzeugten Intermodulationsprodukts vorgegebener Ordnung, eine Vorrichtung wie etwa einen Demodulator und/oder einen Analog/Digital-Konvertierer zum Rückgewinnen eines digitalen Signals aus dem Intermodulationsprodukt-Signal und mindestens einen Detektor und/oder eine Recheneinheit zum Ermitteln der Zeitverschiebung $t_x$. Vorzugsweise weist das Messgerät mindestens ein Verzögerungsglied zum verzögerten Zuleiten des digitalen Signals und/oder des rückgewonnenen digitalen Signals an den mindestens einen Detektor in vorgegebenen Verzögerungsschritten auf.

Zweckmäßigerweise weist der erste Signalgenerator einen Frame-Generator zum Erzeugen eines Frame-Taktsignals, einen Code-Generator zum Erzeugen eines Spreizcodes und eine Spreizungseinheit zum Erzeugen des digitalen Signals aus dem Spreizcode und dem Frame-Taktsignal auf.

Vorzugsweise ist zumindest ein Verstärker zum Verstärken des ersten und/oder des zweiten HF-Signals vor dem Zuführen zu dem Combiner vorgesehen.

Insbesondere sind drei oder mehr Detektoren vorgesehen, denen jeweils das rückgewonnene digitale Signal zugeführt wird, wobei vorzugsweise drei oder mehr Verzögerungsglieder zum Verzögern des den Detektoren zuzuführenden Signals um jeweils eine vorgegebene Zeitverzögerung wie etwa einen Bruchteil der Chipdauer vorgesehen sind.

Das Messgerät kann weitere Bestandteile zum Durchführen der oben beschriebenen Verfahrensschritte einzeln oder in beliebiger Kombination aufweisen.

Die Erfindung wird im Folgenden anhand der Zeichnung näher erläutert, auf die hinsichtlich in der Beschreibung nicht näher herausgestellter erfindungswesentlicher Einzelheiten ausdrücklich verwiesen wird.

Kurzbeschreibung der Figuren

Fig.1     ist eine schematische Darstellung, die einen Signalübertragungspfad von einer BTS bis zu einer Antenne zeigt,

Fig.2     ist ein Blockschaltbild, das den Aufbau eines herkömmlichen Messgeräts zur Entfernungsmessung zeigt,

Fig.3     ist eine Darstellung des Frequenzverlaufs eines Messsignals eines herkömmlichen Messgeräts zur Entfernungsmessung,

Fig.4     ist eine schematische Darstellung eines erfindungsgemäßen Messgeräts zur Durchführung des erfindungsgemäßen Messverfahrens,

rens,

Fig.5     zeigt schematisch die Lage von Sende- und Empfangsband eines Signalübertragungspfads sowie die Lage von Intermodulationsprodukten $f_{PIM}$,

Fig.6     zeigt schematisch das erzeugte erste HF-Signal $u_{Test}$,

Fig. 7    zeigt schematisch die bandbreitenoptimierte Lage der ersten und zweiten HF-Signale sowie der daraus erzeugten Intermodulationsprodukte dritter Ordnung,

Fig. 8    Zeigt schematisch die Laufzeit eines HF-Signals durch den Signalübertragungspfad mit angeschlossenem DUT,

Fig. 9    zeigt schematisch ein Verfahren zur Bestimmung des Ortes einer Störung,

Fig.10    zeigt die Signalformen im Signalgenerator und im Empfänger,

Fig.11    zeigt schematisch die Signallaufzeiten bei der Vermessung eines Signalübertragungspfads,

Fig.12    zeigt die gemessene Leistung von Intermodulationsprodukten in Abhängigkeit von der Verzögerung, und

Fig. 13   zeigt eine weitere Ausführungsform eines Messgeräts zum Durchführen des erfindungsgemäßen Verfahrens anhand eines schematischen Ablaufdiagramms.

Ausführungsform 1: Entfernungsmessung

Im Folgenden wird eine Ausführungsform zur Messung von Entfernung zwischen einem Messgerät und einer Intermodulations-Störung in einem Signalübertragungspfad beschrieben.

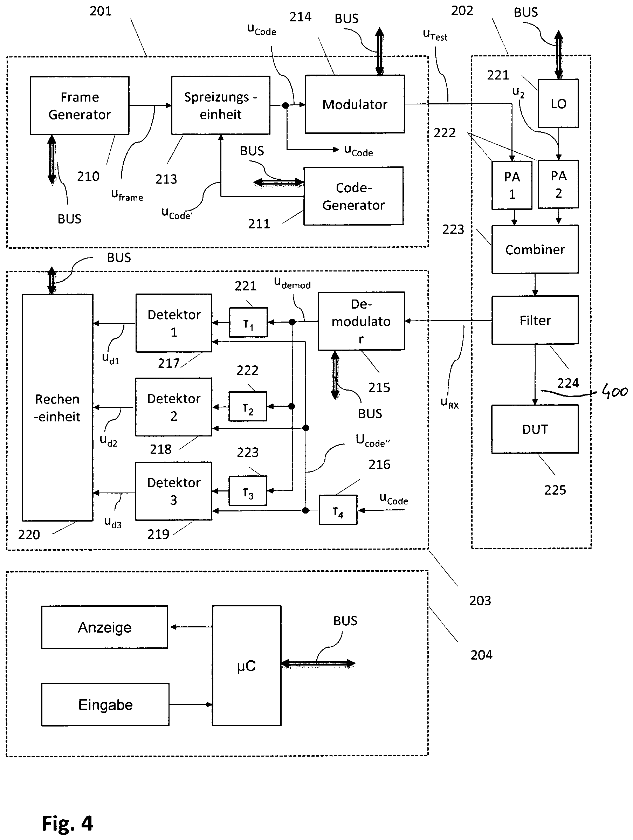

Fig. 4 ist die schematische Darstellung einer ersten Ausführung eines erfindungsmäßigen Messgerätes zur Ausführung des erfindungsmäßigen Verfahrens zur Entfernungsmessung. Diese Ausführungsform besteht aus einem Signalgenerator 201, einem Empfänger 203, einem Übertragungskanal 202 und einer Controller-Einheit 204.

Signalgenerator:

Der Signalgenerator 201 besteht aus einem Frame-Generator 210, einem Code-Generator 211, einer Spreizungseinheit 213 und einem Modulator 214.

Sowohl das Ausgangssignal $u_{frame}$ des Frame-Generators einerseits, als auch das Ausgangssignal des Code-Generators $u_{code}$, andererseits sind mit der Spreizungseinheit verbunden. Das Ausgangssignal $u_{code}$ der Spreizungseinheit ist mit dem Modulator 214 verbunden. Frame-Generator 210, Modulator 214 und Code-Generator 211 sind über den Kommunikationsbus BUS mit der Controller-Einheit 204 verbunden.

Das Ausgangssignal $u_{test}$ wird dem Signalübertragungspfad zugeführt. Je nach Ausführungsform des Messgeräts können ein zweiter Signalgenerator 221, zwei PA 222, ein Combiner 223, eine Filtereinheit 224 und ein DUT 225 vorgesehen sein. Der Signalgenerator 221 ist über den Kommunikationsbus BUS mit der Controller-Einheit 204 verbunden. Durch den Combiner 223 werden die beiden HF-Signale $u_{Test}$ und $u_2$ in den Signalübertragungspfad eingeleitet.

Empfänger:

Der Empfänger besteht aus einem Demodulator 215, vier Verzögerungsgliedern 221, 222, 223 und 216, drei Detektoren 217, 218 und 219 sowie einer Recheneinheit 220. Der Ausgang des Übertragungskanals $u_{rx}$ ist mit dem Eingang des Demodulators 215 verbunden. Das Ausgangssignal $u_{demod}$ des Demodulators 215 ist mit den Verzögerungsgliedern 221, 222 und 223 verbunden. Die Verzögerungsglieder sind jeweils mit einem Detektor 217, 218 und 219 verbunden. Das Verzögerungsglied 216 ist eingangsseitig mit dem Signal $u_{code}$ verbunden, das ausgangsseitige Signal $u_{code"}$ ist mit den drei Verzögerungsgliedern 221, 222 und 223 verbunden. Die drei Verzögerungsglieder 221, 222 und 223 sind mit den Detektoren 217, 218 und 219 verbunden. Die Ausgangssignale $u_{d1}$, $u_{d2}$ und $u_{d3}$ der Detektoren 217, 218 und 219 sind mit der Recheneinheit 220 verbunden. Der Demodulator 215 und die Recheneinheit 220 sind über den Kommunikationsbus BUS mit der Controller-Einheit 204 verbunden.

Im Folgenden werden die Signalformen sowie die Funktionsweise der einzelnen Module beschrieben.

Bänder, Frequenzen bei der PIM-Messung:

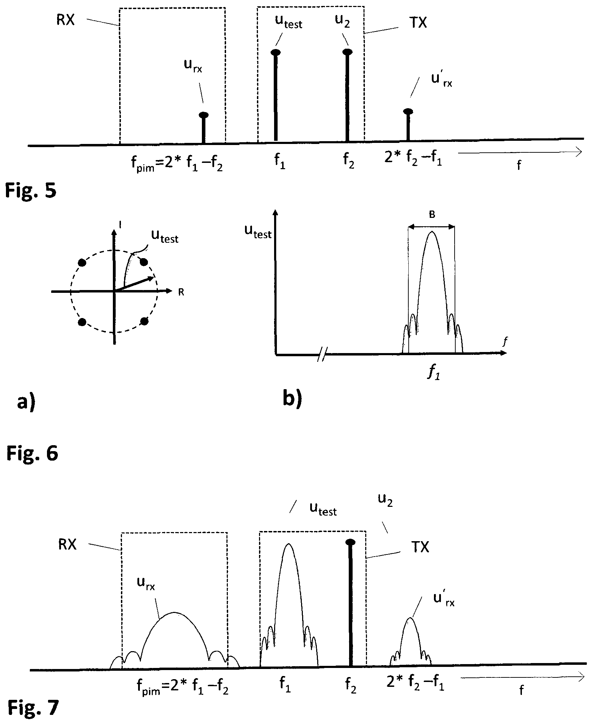

In dem beschriebenen Verfahren ist es vorgesehen, den Modulator 214 und LO 221 des in Fig. 4 dargestellten Messgeräts vor einem Messvorgang zu konfigurieren. Die Lage und Bezeichnungen der für die Übertragungseinrichtung wesentlichen Bänder und Frequenzen sind in Fig. 5 ersichtlich. Das Sendeband einer Übertragungseinrichtung wird im Folgenden mit TX, das Empfangsband mit RX bezeichnet. Die beiden Signale $u_{test}$ bzw. $u_2$ haben die Frequenzen $f_1$ bzw. $f_2$. An der Nichtlinearität im Signalübertragungspfad einschließlich des DUT werden Intermodulationsprodukte unterschiedlicher Ordnung o erzeugt, wobei gilt

$$f_{pim} = nf_1 + mf_2 \qquad (2)$$

$$o = |n| + |m| \qquad (3)$$

Die Variablen m, n, o sind ganze Zahlen. In Fig. 5 sind die Intermodulationsprodukte 3. Ordnung beispielhaft aufgezeigt. Das Signal $u_{rx}$ fällt dabei ins relevante Empfangsband RX, das Signal $u'_{rx}$ liegt außerhalb des Empfangsbandes und wird in Filter 224 entsprechend unterdrückt. Zur Einstellung der beiden Frequenzen $f_1$ und $f_2$ wird in der beschriebenen Ausführungsform nach Eingabe der Lage von TX und RX in der Controller-Einheit gemäß (2) und (3) berechnet, in welchen Frequenzkonstellationen die $f_{PIM}$ innerhalb RX liegt. Über den Kommunikationsbus BUS wird der Wert von $f_1$ an den Modulator 214, der Wert von $f_2$ an den LO 221 und der Wert von $f_{PIM}$ an den Demodulator 215 übertragen.

Entfernungsmessung:

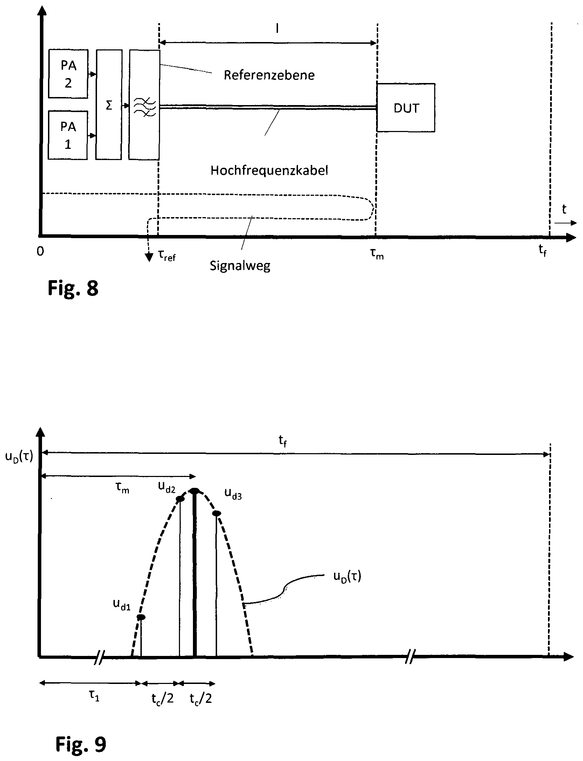

In Fig. 8 werden die Verzögerungen des Signals $u_{rx}$ im Vergleich zum Signal $u_{test}$ dargestellt. Bis zum Ausgang des Filters, welcher üblicherweise die ReferenzEbene einer Messung darstellt, wird das Signal $u_{test}$ um $T_{ref}$ verzögert. Ab der Referenzebene durchläuft das Testsignal, wie in Fig. 8 beispielhaft dargestellt ist, ein Hochfrequenzkabel der Länge l, welches mit dem DUT verbunden ist und einen Teil des Signalübertragungspfads bildet. Das Signal $u_{rx}$ wird durch PIM erzeugt und im Filter gemessen. Die Laufzeit zwischen der Referenzebene und dem Filter ist demgemäß $\Delta T=2(T_m-T_{ref})$. Die Länge l bis zur Störung kann demgemäß bestimmt werden durch

$$l = \frac{2c_0(\tau_m - \tau_{ref})}{\varepsilon_{reff}} \qquad (4)$$

Zur genauen Messung von $T_m$ werden im Signalgenerator 201 spezielle Signale erzeugt und im Empfänger 203 auf geeignete Weise empfangen.

Erzeugung des Sendesignals:

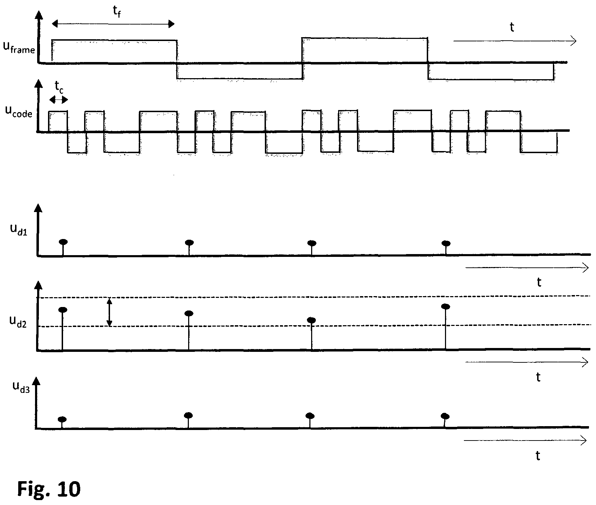

Im Folgenden wird die Erzeugung des Signals $u_{code}$ des Signalgenerators gemäß Fig. 4 erläutert. Der Frame-Generator 210 erzeugt ein periodisches Frame-Signal $u_{frame}$. Das Frame-Signal $u_{frame}$ ist in Fig. 10 dargestellt. Die Zeitdauer eines Frame-Signals ist dabei $t_f$. Im Code-Generator 211 wird ein digitaler Code erzeugt, welcher aus einer Folge von {-1; 1} besteht. Der Code hat dabei die Länge lc. Die Folge von {-1; 1} wird zweckmäßigerweise derart gewählt, dass die Auto-Korrelation der Folge für Verschiebungen ungleich 0 minimal ist. Das Signal $u_{code}$ gemäß Fig. 10 enthält eine Folge von digitalen Impulsen, im Folgenden Chip genannt, und entsteht in der Spreizungseinheit durch zyklische Multiplikation von $u_{frame}$ mit dem Code. Die Chip-Länge $t_c$ ist dabei gegeben durch

$$t_c = \frac{t_f}{lc} \qquad (5)$$

Modulationsverfahren:

Im Folgenden wird die Funktionsweise des Modulators 214 gem. Fig. 4 dargestellt. Das Signal $u_{Code}$ wird im Modulator 214 mit einem bandbreiteneffizienten Modulationsverfahren auf einen Hochfrequenzträger mit der Frequenz $f_1$ moduliert. Wesentlich für die Wahl eines Modulationsverfahrens sind die benötigte Bandbreite B sowie die Gestalt des Konstellationsdiagramms. Hat im Konstellationsdiagramm der Zeiger des Signals eine konstante Länge, so können kostengünstigere PA zur Anwendung kommen im Vergleich zu Verfahren mit variabler Länge des Signal-Zeigers. In der beschriebenen Ausführungsform wird Minimum Shift Keying (MSK) als Modulationsverfahren verwendet. Das Konstellationsdiagramm von $u_{test}$ ist in Fig. 6a dargestellt. Der Zeiger von $u_{test}$ weist dabei konstante Länge auf. Das Frequenzspektrum von $u_{test}$ ist in Fig. 6b dargestellt. Die benötigte Bandbreite B, innerhalb welcher 99% der Energie des Signals liegen beträgt im Falle von MSK

$$B = 1{,}18 \frac{1}{t_c} \qquad (6)$$

Das Signal $u_{rx}$ weist durch den Intermodulationseffekt die Bandbreite $B_{rx}$ auf:

$$B_{rx} = 1{,}18 \frac{o}{t_c} \qquad (7)$$

Die Parameter $t_c$, $f_1$ und $f_2$ können so gewählt werden, dass $f_{PIM}$ mittig im RX Band liegt. Dies ist in Fig. 7 veranschaulicht.

Empfang und Entfernungsberechnung:

Im Folgenden wird die Funktionsweise des Empfängers 203 gem. Fig. 4 beschrieben. Im Demodulator 215 wird das Signal $u_{RX}$ mit der Frequenz $f_{PIM}$ empfangen und demoduliert. Das demodulierte Signal $u_{demod}$ wird über die drei Verzögerungsglieder 221, 222 und 223 jeweils den Detektoren 217, 218 und 219 zugeführt. Die drei Verzögerungszeiten T1, T2 und T3 werden vorteilhafterweise so gewählt, dass gilt:

$$\tau_2 = \tau_1 + \frac{1}{2} t_c \qquad (8)$$

$$\tau_3 = \tau_2 + \frac{1}{2} t_c \qquad (9)$$

Ein weiteres Verzögerungsglied 216 verzögert das Signal $u_{code}$, wobei $T_4$ zweckmäßigerweise so gewählt wird, dass

$$\tau_4 = t_f \qquad (10)$$

Durch Multiplikation des um eine Zeit T verzögerten Signals $u_{demod}$ mit dem Signal $u_{code"}$ entsteht am Ausgang eines Detektors ein Signal $u_d$ welches die Empfangsleistung der PIM anzeigt. Die Abhängigkeit des Signales $u_d$ von der Verzögerung ist beispielhaft in Fig. 9 dargestellt. Abhängig vom gewählten Modulationsverfahren und vom gewählten Code fällt das Signal $u_d$ für Werte $T \neq T_m$ schnell ab. Die 3 Detektoren messen das Signal $u_d$ zu unterschiedlichen Zeitpunkten $T_1$, $T_2$ und $T_3$, die Ausgangssignale werden mit $u_{d1}$, $u_{d2}$ und $u_{d3}$ bezeichnet. In Fig. 4 sind diese beispielhaft dargestellt. Die Verzögerung $T_1$ gemäß den Gleichungen (8) und (9) werden solange verändert, bis das Signal $u_{d2}$ maximal ist.

Aus den drei Signalen $u_{d1}$, $u_{d2}$ und $u_{d3}$ wird in der Recheneinheit die genaue Verzögerungszeit des Signals $u_{rx}$ im Vergleich zu $u_{test}$ abgeschätzt. Dies geschieht beispielsweise mit einem in Fig. 9 veranschaulichten Verfahren. Der Verlauf von u(T) wird durch eine Parabel gemäß

$$u_{rx}(\tau) = a_0 + a_1 \tau + a_2 \tau^2 \qquad (11)$$

angenähert. Aus den drei Werten $u_{d1}$, $u_{d2}$ und $u_{d3}$ werden die drei Parameter $a_0$, $a_1$ und $a_2$ bestimmt. Aus Gleichung (6) wird in der Rechen-Einheit der Wert $T_m$ ermitteln. Durch die periodische Wiederholung des Codes mit der Periodendauer $t_f$ ergibt sich ein Eindeutigkeitsbereich, welcher in Fig. 9 angezeigt ist. Der wesentliche Vorteil des offengelegten Verfahrens ist die hohe Genauigkeit, die erreicht werden kann.

Ausführungsform 2: Zeitfensterverfahren

Im Folgenden wird in einer zweiten Ausführungsform eine weitere Zweckmäßigkeit des Verfahrens beschrieben. Ein Messgerät gemäß Fig. 4 kann durch die Anwendung eines Zeitfensterverfahrens in seiner Auflösung wesentlich verbessert werden.

Prinzip der Eigenstörung und der multiplen Störungen:

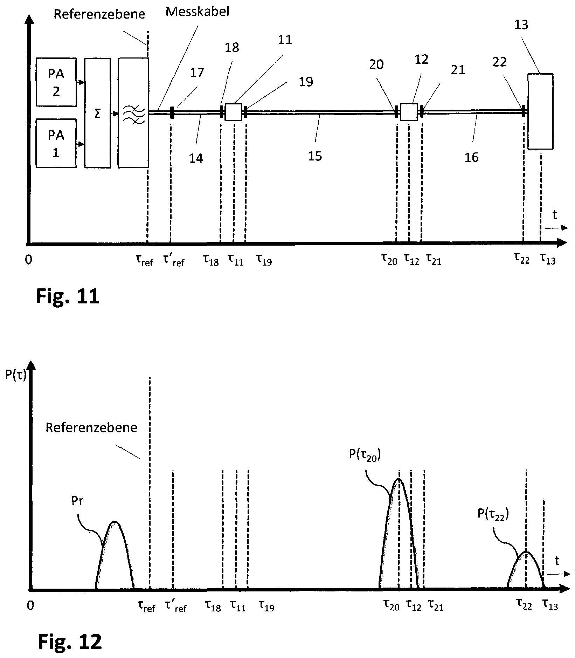

Der Zweck des Messgeräts gemäß Fig. 4 ist es nicht nur, die Entfernung zwischen Störstelle und Messgerät zu erfassen, sondern auch seine Leistung. Im Beispiel der Übertragungsstrecke gemäß Fig. 1 befinden sich mehrere Stellen, an welchen in dem Signalübertragungspfad von BTS bis zur Antenne Intermodulation entstehen kann. In Fig. 11 sind die einzelnen Module des Signalübertragungspfads gemäß Fig. 1 zusammen mit der Messeinrichtung gemäß Fig. 4 aufgetragen. Der Signalübertragungspfad verläuft ausgehend von dem Messgerät über ein Übertragungskabel. Die Intermodulationen an den einzelnen möglichen Störstellen, namentlich den Steckverbindern 17, 18, 19, 20, 21, 22, an den Filtern 11 und 12 und in der Antenne 13 haben gemäß Fig. 11 unterschiedliche Verzögerungszeiten T.

Intermodulationsprodukte können allerdings nicht nur in der Übertragungsstrecke zwischen BTS und Antenne, sondern auch innerhalb des Messgerätes entstehen. Die Intermodulationsstörungen, welche in der Messeinrichtung entstehen werden im Folgenden mit rPIM (residual PIM) bezeichnet.

Zuordnung der zeitlichen Störung:

Durch das erfindungsgemäße Verfahren ist es möglich, die Leistung der PIM abhängig von der Verzögerungszeit T zu messen, indem in dem Messgerät gemäß Fig. 4 die Werte von $T_1$, $T_2$ und $T_3$ unter Berücksichtigung von (8) und (9) systematisch variiert werden. $T_2$ wird dabei beispielsweise schrittweise mit 0 startend in Schritten von ½ $t_c$ vergrößert bis T=$t_f$ erreicht ist. $t_f$ kann länger gewählt sein als die Durchlaufzeit durch den gesamten Signalübertragungspfad. Der Verlauf der so gemessenen Leistung in Abhängigkeit von der Verzögerung ist beispielhaft in Fig. 12 dargestellt für den Fall, dass eine Eigenstörung rPIM (bezeichnet mit $P_r$) und eine Störung am Steckverbinder 20 und am Steckverbinder 22 auftreten.

Ausblenden der Störung:

In Messgeräten nach dem Stand der Technik wird die Eigenstörung nicht gesondert erfasst. Die Auflösung der Messeinrichtung wird demzufolge durch die Eigenstörung begrenzt. In der offengelegten Ausführungsform wird entweder die Leistung abhängig von der Verzögerungszeit angezeigt, wobei nur PIM außerhalb des Messgeräts zur Anzeige kommt. Alternativ werden die addierten Leistungen Ps angezeigt

$$P_s = \sum_{i=1}^{n} P(\tau_i); \quad \tau_i > \tau'_{ref} \quad (12)$$

Ein Vorteil dieses Verfahrens ist es, die Messgenauigkeit der Messeinrichtung wesentlich zu erhöhen.

Ausführungsform 3: Ortung einer Fehlstelle

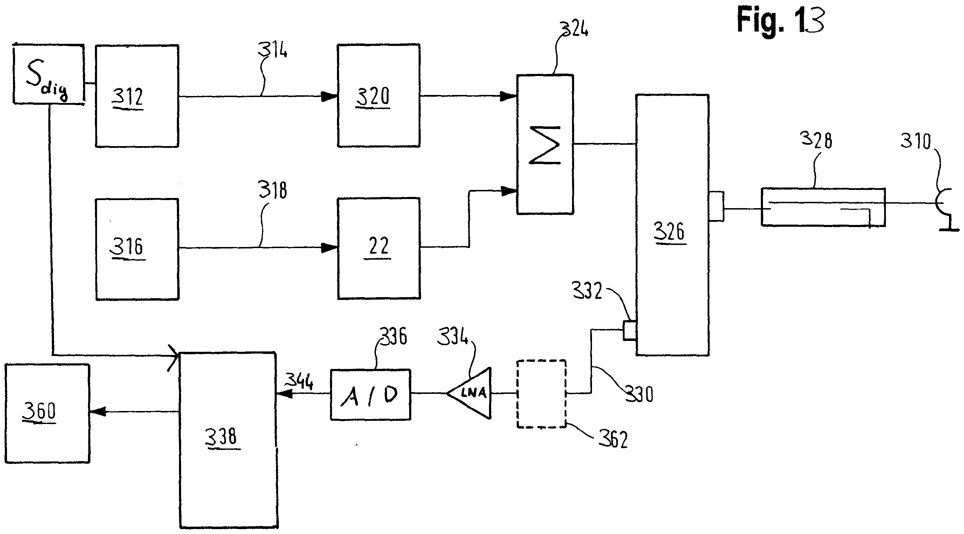

Die in Fig. 13 beispielhaft dargestellte weitere Ausführungsform des erfindungsgemäßen Verfahrens betrifft die Analyse eines Signalübertragungspfades, welcher an einem Einleitungspunkt 310 elektrisch angeschlossen ist, hinsichtlich von Störstellen, welche die HF-Übertragungseigenschaften beeinträchtigen. Diese Störstellen verursachen eine nichtlineare Übertragungsfunktion hinsichtlich der Übertragung von HF-Signalen. Mit dem vorliegenden Verfahren wird ausgenutzt, dass derartige nichtlineare Übertragungsfunktionen zur Erzeugung von Intermodulationsprodukten führen, wenn zwei HF-Signale unterschiedlicher Frequenz gleichzeitig auf eine derartige Stelle mit nichtlinearer Übertragungsfunktion treffen. Diese Intermodulationsprodukte werden an diesen Stellen erzeugt und stellen keine Reflexion eines eingespeisten Signals, sondern ein neues, zuvor in dem Signalübertragungspfad nicht vorhandenes HF-Signal dar, welches hierin als Intermodulationssignal oder auch Intermodulationsprodukt bezeichnet wird.

In einem ersten Block 312 wird ein erstes HF-Signal 314 mit einer vorbestimmten, konstanten Frequenz $f_1$ erzeugt. Diesem ersten HF-Signal 314 wird ein digitales Signal $S_{dig}$, beispielsweise ein digitales Rauschsignal, aufmoduliert. Hierbei wird als Modulationsverfahren beispielsweise eine I/Q-Modulation verwendet, es ist jedoch auch möglich, jede andere bekannte Modulationsart zu verwenden. In einem zweiten Block 316 wird ein zweites HF-Signal 318 mit einer vorbestimmten, konstanten Frequenz $f_2$ erzeugt.

In einem dritten Block 320 wird das erste HF-Signal 314 und einem vierten Block 322 wird das zweite HF-Signal 318 verstärkt. Nach der Verstärkung in den Blöcken 320 und 322 werden die beiden HF-Signale 314, 318 einem Combiner 324 zugeführt. Der Combiner 324 führt die auf eine Leitung kombinierten HF-Signale 314, 318 einem fünften Block 326 zu, der einen Duplexfilter enthält und das erste sowie zweite HF-Signal 314, 318 über einen Koppler 328 an dem Einleitungspunkt 310 in den Signalübertragungspfad einspeist. Diese beiden HF-Signale 314, 318 treffen nun auf ihrem Weg durch den Signalübertragungspfad ggf. auf eine Stelle mit nichtlinearer Übertragungsfunktion, beispielsweise einen defekten HF-Steckverbinder, eine schlechte Lötstelle oder einen Kabelbruch, so dass aus den beiden HF-Signalen 314, 318 an sich unerwünschte Intermodulationsprodukte, wie beispielsweise das Intermodulationsprodukt 3. Ordnung IM3 (bspw. 2 mal erstes HF-Signal minus 1 mal zweites HF-Signal o. dgl.), erzeugt werden. Die Frequenz des erzeugten Intermodulationsprodukts $f_{PIM}$ 3. Ordnung IM3 330 ergibt sich somit aus der Trägerfrequenz $f_1$ des ersten HF-Signals 314 und aus der Frequenz $f_2$ des zweiten HF-Signals 318 gemäß der Gleichung $2xf_1$-$f_2$. Die Intermodulationsprodukte laufen als in dem Signalübertragungspfad erzeugte Signale bzw. Intermodulationsprodukte bzw. Intermodulationsproduktsignale zu dem Einleitungspunkt 310 zurück.

Mittels des fünften Blockes 326 wird gleichzeitig am Einleitungspunkt 310 ein in dem Signalübertragungspfad erzeugtes Signal empfangen und mittels des Duplexfilters das Intermodulationsprodukt 3. Ordnung IM3 330 mit einer Frequenz $f_{PIM}$ herausgefiltert und über einen Ausgang 332 ausgegeben. Dieses empfangene IM3 330 wird über einen Verstärker "LNA -low noise amplifier" 334 und einen A/D-Wandler 336 an einen sechsten Block 338 übergeben. Der A/D Wandler 336 erzeugt ein digitales Signal 344 $u_{demod}$, das im Wesentlichen dem ursprünglichen digitalen Signal $S_{dig}$ entspricht, aber zeitlich gegenüber diesem aufgrund der Laufzeit durch den Signalübertragungspfad versetzt ist.

Auch das ursprüngliche digitale Signal $S_{dig}$ wird an den sechsten Block 338 übergeben. Das digitale Signal $S_{dig}$ und das digitale Signal $u_{demod}$, das der A/D-Wandler 336 bereitstellt, liegen aufgrund von Laufzeitunterschieden zeitlich zueinander versetzt vor, da das empfangene Intermodulationsprodukt IM3 330 zusätzlich mindestens den Weg L zu der Stelle mit nichtlinearer Übertragungsfunktion sowie den Weg L wieder zurück von der Stelle mit nichtlinearer Übertragungsfunktion zum Einleitungspunkt 310 zurückgelegt hat.

In dem Block 338, welcher beispielsweise als FPGA ("Field Programmable Gate Array) ausgebildet ist, werden die Signale $u_{demod}$ und $S_{dig}$ miteinander verglichen. Dies kann mittels einer Kreuzkorrelation erfolgen. Aus dem Maximum der Kreuzkorrelationsfunktion kann ein Laufzeitunterschied $t_x$ zwischen den beiden Signalen bestimmt werden.

Mit anderen Worten werden mittels der Kreuzkorrelation die Amplitudenverläufe der beiden Signale solange gegeneinander zeitlich verschoben, bis die beiden Amplitudenverläufe deckungsgleich sind. Die hierfür erforderliche Verschiebung t entspricht genau der Laufzeitdifferenz $t_x$ zwischen den beiden Signalen.

Aus diesem Laufzeitunterschied bzw. dieser Laufzeitdifferenz $t_x$ lässt sich auf einfache Weise die Länge l zwischen dem Einleitungspunkt 310 und der gesuchten fehlerhaften Stelle in dem Signalübertragungsweg gemäß

$$ l = \tfrac{1}{2} \cdot t_x \cdot c $$

bestimmen, wobei c eine Ausbreitungsgeschwindigkeit von HF-Signalen in dem Signalübertragungspfad ist. Diese Entfernung L ist die Strecke von dem Einleitungspunkt 310 bis zu einer Stelle, an der das Intermodulationsprodukt 3. Ordnung IM3 330 in dem Signalübertragungspfad aus dem ersten und zweiten HF-Signal 314, 318 erzeugt wurde.

Es muss nun nur noch diese Entfernung bzw. Länge l am Signalübertragungspfad 310 abgemessen werden und man erhält genau den Ort im Signalübertragungspfad 310 an dem sich ein Fehler mit nichtlinearer Übertragungsfunktion befindet, die die HF-Übertragungseigenschaften des Signalübertragungspfades 310 beeinträchtigt. Dies kann ein Bruch in einem HF-Kabel oder eine Fehlerstelle in der Antenne oder ein defekter HF-Steckverbinder oder eine fehlerhafte Lötstelle sein.

Es können selbstverständlich auch mehrere fehlerhafte Stellen gleichzeitig in dem Signalübertragungspfad vorhanden sein. In diesem Falle ergeben sich mehrere zeitlich versetzte, empfangene Intermodulationsprodukte IM3 330 die alle gleichzeitig ausgewertet werden können, so dass mehrere Laufzeitdifferenzen $t_x$ und mehrere Längen l bestimmt werden können. Dadurch, dass als betrachtetes empfangenes Signal ein neu erzeugtes Intermodulationsprodukt verwendet wird, ist sichergestellt, dass die Länge l eine fehlerhafte Stelle mit nichtlinearer Übertragungsfunktion und keine sonstige Reflexion eines HF-Signals mit anderen Ursachen oder anderen Quellen betrifft.

Der Block 338 ist zur Steuerung und Datenausgabe mit einem Computer 360 verbunden.

Bei der in Fig. 1 dargestellten, bevorzugten Ausführungsform des erfindungsgemäßen Verfahrens wird das Intermodulationsprodukt 3. Ordnung IM3 verwendet. Dies ist jedoch lediglich beispielhaft und es können auch andere Intermodulationsprodukte verwendet werden, wie beispielsweise das Intermodulationsprodukt 2. Ordnung, 4. Ordnung, 5. Ordnung oder höher. Wichtig ist lediglich, dass das ursprüngliche digitale Signal in dem A/D-Konverter 336 aus dem Intermodulationsprodukt korrekt wiedergewonnen wird.

Zweckmäßigerweise wird eine Vorrichtung zum Ausführen des erfindungsgemäßen Verfahrens vor der ersten Messung kalibriert, um messungsbedingte Laufzeiten der miteinander in Block 338 verglichenen Signale in der Auswerteelektronik vor dem Einleitungspunkt 310 außerhalb des Signalübertragungspfades zu eliminieren.

Optional ist ein Frequenzumsetzer (Down-Konverter) 362 für das empfangene IM3 330 vorgesehen, der die Frequenz des IM3 auf eine für den LNA 334 und den A/D-Wandler 336 geeignete Frequenz umsetzt.

Das erfindungsgemäße Verfahren ist nicht auf die beschriebenen Ausführungsformen beschränkt. Vielmehr kann das digitale Signal auch anders aufgebaut sein und/oder auch das zweite HF-Signal kann ein aufmoduliertes digitales Signal o.dgl. aufweisen.

**Patentansprüche**

1. Verfahren zum Orten von Stellen in einem Signalübertragungspfad (400) für ein Hochfrequenzsignal, die im Sinne von Hochfrequenzübertragungseigenschaften des Signalübertragungspfades fehlerhaft sind, wobei ein erstes HF-Signal $u_{Test}$ mit einer Trägerfrequenz $f_1$ erzeugt wird, **gekennzeichnet durch** folgende Schritte:

(a) Aufmodulieren eines digitalen Signals $u_{Code}$ auf das erste HF-Signal $u_{Test}$;
(b) Erzeugen eines zweiten HF-Signals $u_2$ mit einer Frequenz $f_2$;
(c) Einleiten des ersten HF-Signals $u_{Test}$ und des

zweiten HF-Signals $u_2$ in den Signalübertragungspfad (400) an einem vorbestimmten Einleitungspunkt;

(d) Empfangen eines in dem Signalübertragungspfad aus dem ersten HF-Signal und dem zweiten HF-Signal an zumindest einer fehlerhaften Stelle erzeugten und zum Einleitungspunkt zurückreflektierten Intermodulationsproduktes in Form eines Intermodulationsprodukt-Signals $u_{RX}$;

(e) Rückgewinnung eines digitalen Signals $u_{demod}$ aus dem Intermodulationsprodukt-Signal;

(f) Bestimmen einer Zeitverschiebung $t_x$ zwischen dem digitalen Signal $u_{Code}$ und dem rückgewonnenen digitalen Signal $u_{demod}$ und

(g) Berechnen einer Länge L zwischen dem Einleitungspunkt und derjenigen Stelle in dem Signalübertragungspfad, an der das in Schritt (d) empfangene Signal erzeugt wurde, aus der in Schritt (f) bestimmten Zeitverschiebung $t_x$.

2. Verfahren nach Anspruch 1, **dadurch gekennzeichnet, dass** zur Erzeugung des digitalen Signals $u_{Code}$ in Schritt (a) ein bevorzugt periodisches Frame-Taktsignal $u_{frame}$ mit einem Spreizcode $u_{Code'}$ multipliziert wird.

3. Verfahren nach Anspruch 2, **dadurch gekennzeichnet, dass** der Spreizcode $u_{code}$ eine Folge von Chips aufweist, wobei eine Länge des Frame-Takts des Frame-Taktsignals $u_{frame}$, eine Länge des Spreizcodes $u_{Code'}$ und/oder die Anzahl an Chips des Spreizcodes $u_{Code'}$ derart berechnet werden, dass sich eine an die Länge des Signalübertragungspfads (400) und/oder an eine zu verwendende Sende- und/oder Empfangsbandbreite des Signalübertragungspfads angepasste resultierende Bandbreite des ersten HF-Signals $u_{Test}$ und/oder des Intermodulationsproduktsignals $u_{RX}$ ergibt.

4. Verfahren nach einem der vorhergehenden Ansprüche, **dadurch gekennzeichnet, dass** in Schritt (a) ein bandbreiteneffizientes digitales Modulationsverfahren wie etwa Frequency Shift Keying FSK, bevorzugt Continuous-phase frequency-shift keying CPFSK, insbesondere Minimum Shift Keying MSK verwendet wird.

5. Verfahren nach einem der vorhergehenden Ansprüche, **dadurch gekennzeichnet, dass** die Länge L gemäß der Formel $L = \frac{1}{2} \cdot t_x \cdot c$ berechnet wird, wobei c eine Ausbreitungsgeschwindigkeit von HF-Signalen in dem Signalübertragungspfad ist.

6. Verfahren nach einem der vorhergehenden Ansprüche, **dadurch gekennzeichnet, dass** in Schritt (f) das digitale Signal $u_{Code}$ und das rückgewonnene digitale Signal $u_{demod}$ in ihrer Phasenlage relativ zueinander solange gegeneinander verschoben werden, bis die digitalen Signale deckungsgleich sind und/oder das Produktsignal im Wesentlichen maximal ist, wobei aus der erforderlichen Zeitverschiebung für die Deckungsgleichheit oder das Maximum die Zeitdifferenz $t_x$ bestimmt wird.

7. Verfahren nach einem der vorhergehenden Ansprüche, **dadurch gekennzeichnet, dass** in Schritt (f) das rückgewonnene digitale Signal $u_{demod}$ mit unterschiedlichen Verzögerungen, bspw. mit einem Abstand von jeweils einem vorgegebenen Bruchteil einer Chipdauer wie etwa einer halben Chipdauer, an drei oder mehr Empfänger geleitet wird und darin jeweils mit dem ggf. ebenfalls verzögerten digitalen Signal $u_{Code}$ multipliziert wird, oder umgekehrt.

8. Verfahren nach Anspruch 6 und 7, **dadurch gekennzeichnet, dass** das Produktsignal in Abhängigkeit von der Zeitverschiebung durch eine Polynomfunktion, insbesondere durch eine Parabel, angenähert wird, deren Koeffizienten aus den von den drei oder mehr Empfängern bestimmten Multiplikationswerten berechnet werden, wobei anschließend vorzugsweise zumindest ein Maximum der Polynomfunktion aus den Koeffizienten berechnet wird.

9. Verfahren nach einem der vorhergehenden Ansprüche, **dadurch gekennzeichnet, dass** die Zeitverschiebung in Schritt (f) mittels einer Kreuzkorrelation bestimmt wird.

10. Verfahren nach mindestens einem der vorhergehenden Ansprüche, **dadurch gekennzeichnet, dass** in Schritt (d) ein Intermodulationsprodukt dritter Ordnung IM3, insbesondere das Intermodulationsprodukt mit der Trägerfrequenz $2 \times f_1 - f_2$ oder $2 \times f_2 - f_1$ empfangen wird.

11. Verfahren nach mindestens einem der vorhergehenden Ansprüche, **dadurch gekennzeichnet, dass** das in Schritt (d) empfangene Signal $u_{RX}$ an mehreren fehlerhaften Stellen des Signalübertragungspfads erzeugte Intermodulationssignalanteile aufweist, wobei mindestens eine Größe eines der Intermodulationssignalanteile wie etwa eine Zeitverschiebung bzgl. eines weiteren Intermodulationssignalanteils oder bzgl. des digitalen Signals $u_{Code}$, ein Verlauf, eine Amplitude, eine Leistung o.dgl. bestimmt werden.

12. Verfahren nach Anspruch 11, **dadurch gekennzeichnet, dass** mindestens eine Gesamtgröße wie etwa die Gesamtleistung, die Signalstärke o.dgl. der in einem vorgegebenen Teilabschnitt wie etwa einem Eingangsabschnitt oder einem Messabschnitt des Signalübertragungspfads erzeugten Intermodulationsanteile bestimmt werden.

**13.** Verfahren nach Anspruch 11 oder 12, **dadurch gekennzeichnet, dass** ein Maß für die Leistung von Intermodulationssignalanteilen in Abhängigkeit von ihrem Erzeugungsort und/oder ein Maß für die addierte Leistung von Intermodulationssignalanteilen mit einer Verzögerungszeit $t_x > x$, x = eine vorgegebene Schwellenverzögerung $t_{min}$ bestimmt werden.

**14.** Messgerät zum Durchführen eines Verfahrens nach einem der vorhergehenden Ansprüche.

**Claims**

**1.** Method for locating points in a signal transmission path (400) for a radio-frequency signal which are faulty with regard to radio-frequency transmission properties of the signal transmission path, wherein a first RF signal $u_{Test}$ which has a carrier frequency $f_1$ is generated,
**characterised by** the following steps:

(a) modulating a digital signal $u_{Code}$ onto the first RF signal $u_{Test}$;
(b) generating a second RF signal $u_2$ having a frequency $f_2$;
(c) introducing the first RF signal $u_{Test}$ and the second RF signal $u_2$ into the signal transmission path (400) at a predetermined introduction point;
(d) receiving an intermodulation product, which is generated in the signal transmission path from the first RF signal and the second RF signal at at least one faulty point and reflected back to the introduction point, in the form of an intermodulation product signal $u_{RX}$;
(e) recovering a digital signal $u_{demod}$ from the intermodulation product signal preferably through modulation;
(f) determining a time shift $t_x$ between the digital signal $u_{Code}$ and the recovered digital signal $u_{demod}$; and
(g) calculation of the length L between the introduction point and the point in the signal transmission path at which the signal received in step (d) was generated from the time shift $t_x$ determined in step (f).

**2.** Method according to claim 1, **characterised in that** in order to generate the digital signal $u_{Code}$ in step (a) a preferably periodic frame-clock signal $u_{frame}$ is multiplied by a spreading code $u_{Code'}$.

**3.** Method according to claim 2, **characterised in that** the spreading code $u_{Code'}$ has a sequence of chips, wherein a length of the frame-clock of the frame-clock signal $u_{frame}$, a length of the spreading code $u_{code}$ and/or the number of chips of the spreading code $u_{Code'}$ are calculated such that a resulting bandwidth of the first RF signal $u_{Test}$ and/or of the intermodulation product signal $u_{RX}$ adapted to the length of the signal transmission path (400) and/or to a used transmission and/or reception bandwidth of the signal transmission path is obtained.

**4.** Method according to one of the preceding claims, **characterised in that** a bandwidth-efficient digital modulation method such as Frequency Shift Keying FSK, preferably Continuous Phase Frequency Shift Keying CPFSK, in particular Minimum Shift Keying MSK is used in step (a).

**5.** Method according to one of the preceding claims, **characterised in that** the length L is calculated according to the formula

$$L = \tfrac{1}{2} \cdot t_x \cdot c \,,$$

where c is a speed of propagation of RF signals in the signal transmission path.

**6.** Method according to one of the preceding claims, **characterised in that** in step (f) the relative phase positions of the digital signal $u_{Code}$ and the recovered digital signal $u_{demod}$ are shifted relative to one another until the digital signals are congruent, and/or the product signal is substantially at a maximum, wherein the time difference $t_x$ is determined from the phase shift required to achieve congruence or the maximum.

**7.** Method according to one of the preceding claims, **characterised in that** in step (f) the recovered digital signal $u_{demod}$ is passed with different predefined delays, for example at intervals of in each case a predefined fraction of a chip duration such as half a chip duration, to three or more receivers and multiplied therein by the, if necessary delayed, digital signal $u_{Code}$, or vice versa.

**8.** Method according to claims 6 and 7, **characterised in that** the product signal, as a function of the time shift, is approximated through a polynomial function, in particular through a parabola, the coefficients of which are calculated from the multiplication values determined by the three or more receivers, wherein at least one maximum of the polynomial function is then preferably calculated from the coefficients.

**9.** Method according to one of the preceding claims, **characterised in that** the time shift is determined in step (f) by means of a cross-correlation.

10. Method according to at least one of the preceding claims, **characterised in that** a third order intermodulation product IM3, in particular the intermodulation product with the carrier frequency $2 \times f_1 - f_2$ or $2 \times f_2 - f_1$, is received in step (d).

11. Method according to at least one of the preceding claims, **characterised in that** the signal $u_{RX}$ received in step (d) contains intermodulation signal components generated at several faulty points of the signal transmission path, wherein at least one value of one of the intermodulation signal components such as a time shift with respect to a further intermodulation signal component or with respect to the digital signal $u_{Code}$, a curve, an amplitude, a power or similar are determined.

12. Method according to claim 11, **characterised in that** at least one overall value such as the overall power, the signal strength or similar of the intermodulation components generated in a predefined partial section such as an input section or a measuring section of the signal transmission path is determined.

13. Method according to claim 11 or 12, **characterised in that** a measure for the power of intermodulation signal components depending on their point of generation and/or a measure for the added power of intermodulation signal components with a delay time $t_x > x$, where x is a predefined threshold delay $t_{min}$ are determined.

14. Measuring device for carrying out a method according to one of the preceding claims.

**Revendications**

1. Procédé de localisation d'emplacements dans un chemin de transmission de signaux (400) pour un signal haute fréquence, qui sont défectueux dans le sens des propriétés de transmission haute fréquence du chemin de transmission de signaux, dans lequel on génère un premier signal haute fréquence $U_{Test}$ à une première fréquence porteuse $f_1$, **caractérisé par** les étapes suivantes consistant à :

   (a) moduler un signal numérique $u_{Code}$ sur le premier signal haute fréquence $u_{Test}$ ;
   (b) générer un second signal haute fréquence $u_2$ à une fréquence $f_2$ ;
   (d) injecter le premier signal haute fréquence $u_{Test}$ et le second signal haute fréquence $u_2$ dans le chemin de transmission de signaux (400) à un point d'injection prédéterminé ;
   (d) recevoir un produit d'intermodulation généré à partir du premier signal haute fréquence et du second signal haute fréquence dans le chemin de transmission de signaux à au moins un emplacement défectueux, et réfléchi vers le point d'injection, sous la forme d'un signal de produit d'intermodulation $u_{RX}$ ;
   (e) récupérer un signal numérique $u_{demod}$ à partir du signal de produit d'intermodulation ;
   (f) déterminer un décalage dans le temps $t_x$ entre le signal numérique $u_{Code}$ et le signal numérique récupéré $u_{demod}$ ;
   (g) calculer une longueur L entre le point d'injection et cet emplacement dans le chemin de transmission de signaux, auquel le signal reçu dans l'étape (d) a été généré, à partir du décalage dans le temps $t_x$ déterminé dans l'étape (f).

2. Procédé selon la revendication 1, **caractérisé en ce que** pour générer le signal numérique $u_{Code}$ dans l'étape (a), on multiplie un signal d'horloge en trame $u_{frame}$ de préférence périodique par un code d'étalement $u_{Code}$.

3. Procédé selon la revendication 2, **caractérisé en ce que** le code d'étalement $u_{Code}$ présente une succession de modulations, dans lequel on calcule une longueur du cycle de trame du signal d'horloge en trame $u_{frame}$, une longueur du code d'étalement $u_{Code}$ et/ou le nombre de modulations du code d'étalement $u_{Code}$, de telle sorte qu'il résulte une largeur de bande résultante du premier signal haute fréquence $u_{Test}$ et/ou du signal de produit d'intermodulation $u_{RX}$, qui est adaptée à la longueur du chemin de transmission de signaux (400) et/ou à une largeur de bande utilisée d'émission et/ou de réception du chemin de transmission de signaux.

4. Procédé selon l'une des revendications précédentes, **caractérisé en ce que** dans l'étape (a) on utilise un procédé de modulation numérique à largeur de bande efficace, tel que Frequency Shift Keying FSK, de préférence Continuous-phase frequency-shift keying CPFSK, en particulier Minimum Shift Keying MSK.

5. Procédé selon l'une des revendications précédentes, **caractérisé en ce que** l'on calcule la longueur L selon la formule $L = \frac{1}{2} \cdot t_x \cdot c$

   c étant une vitesse de propagation de signaux haute fréquence dans le chemin de transmission de signaux.

6. Procédé selon l'une des revendications précédentes, **caractérisé en ce que** dans l'étape (f) le signal numérique $u_{Code}$ et le signal numérique récupéré $u_{demod}$ sont déphasés dans leur phasage l'un par rapport à l'autre aussi longtemps que les signaux numériques se chevauchent et/ou que le signal de produit est sensiblement maximal, en déterminant la différence de temps $t_x$ à partir du décalage dans le temps nécessaire pour ledit chevauchement ou pour ledit maximum.

7. Procédé selon l'une des revendications précédentes, **caractérisé en ce que** dans l'étape (f) le signal numérique récupéré $u_{demod}$ est acheminé avec différents retards, par exemple à une distance d'une fraction donnée respective d'une durée de modulation, telle qu'une moitié de la durée de modulation, à trois récepteurs ou plus, et on le multiplie par le signal numérique $u_{Code}$ le cas échéant retardé, ou inversement.

8. Procédé selon la revendication 6 ou 7, **caractérisé en ce que** le signal de produit est approché en fonction du décalage dans le temps par une fonction polynominale, en particulier par une parabole, dont les coefficients sont calculés à partir des valeurs de multiplication déterminés par les trois récepteurs ou plus, et ensuite on calcule de préférence au moins un maximum de la fonction polynominale à partir des coefficients.

9. Procédé selon l'une des revendications précédentes, **caractérisé en ce que** l'on détermine le décalage dans le temps dans l'étape (f) au moyen d'une corrélation croisée.

10. Procédé selon l'une des revendications précédentes, **caractérisé en ce que** dans l'étape (d) on reçoit un produit d'intermodulation de troisième ordre IM3, en particulier le produit d'intermodulation avec la fréquence porteuse $2 \times f_1 - f_2$ ou $2 \times f_2 - f_1$.

11. Procédé selon l'une des revendications précédentes, caractérisé en ce le signal $u_{RX}$ reçu que dans l'étape (d) présente des parties de signal d'intermodulation générées à plusieurs emplacements défectueux du chemin de transmission de signaux, et on détermine au moins une grandeur de l'une des parties de signal d'intermodulation, comme par exemple un décalage dans le temps par rapport à une autre partie de signal d'intermodulation ou par rapport au signal numérique $u_{Code}$, une évolution, une amplitude, une puissance ou similaire.

12. Procédé selon la revendication 11, **caractérisé en ce que** l'on détermine au moins une grandeur globale telle que la puissance totale, l'intensité de signal ou similaire des parties d'intermodulation générées dans une section partielle prédéterminée, telle qu'une section d'entrée ou une section de mesure du chemin de transmission de signaux.

13. Procédé selon la revendication 11 ou 12, **caractérisé en ce que** l'on détermine une valeur pour la puissance des parties de signal d'intermodulation en fonction de leur emplacement de génération et/ou une valeur pour la puissance additionnée de parties de signal d'intermodulation avec un temps de retard $t_x > x$, x = un retard seuil $t_{min}$ prédéterminé.

14. Appareil de mesure pour mettre en oeuvre le procédé selon l'une des revendications précédentes.

**Fig. 1**

101

102

$u_{sweep}$

$u_{ref}$

$u_b$

$\Sigma$

x2 — 110

X — 111

X — 112

Auswertung — 113

$u_{RX}$

I

DUT

120

**Fig. 2   Stand der Technik**

$f$

$f_1 + \Delta f$

$\Delta f$

$u_{ref}$

$u_{RX}$

$df$

$dt$

$f_1$

$t$

**Fig. 3       Stand der Technik**

**Fig. 4**

**Fig. 5**

a)

b)

**Fig. 6**

**Fig. 7**

**Fig. 8**

**Fig. 9**

**Fig. 10**

**Fig. 11**

**Fig. 12**

Fig. 13

**IN DER BESCHREIBUNG AUFGEFÜHRTE DOKUMENTE**

**In der Beschreibung aufgeführte Patentdokumente**

- DE 19946763 A1
- DE 102012023448 A1

- WO 0227983 A1
- DE 102010015102 A1